# FASCICULE DE BREVET EUROPEEN

(11) **EP 3 828 943 B1**
(45) Date de publication et mention de la délivrance du brevet: **05.10.2022**
(21) Numéro de dépôt: 20209299.5
(22) Date de dépôt: 23.11.2020
(51) Int. Cl.: H01L 41/09

(54) **MICROSYSTÈME MÉCANIQUE ET PROCÉDÉ DE FABRICATION ASSOCIÉ**
MECHANISCHES MICROSYSTEM MIT ENTSPRECHENDEM HERSTELLUNGSPROZESS
MECHANICAL MICROSYSTEM AND CORRESPONDING PRODUCTION PROCESS

(30) Priorité: 28.11.2019 FR 1913425
(43) Date de publication de la demande: 02.06.2021
(73) Titulaire: Commissariat à l'Energie Atomique et aux Energies Alternatives, 75015 Paris (FR)
(72) Inventeur: HILT, Thierry, 38054 GRENOBLE (FR); DIEPPEDALE, Christel, 38054 GRENOBLE (FR); MOLLARD, Laurent, 38054 GRENOBLE (FR)
(74) Mandataire: Hautier IP

(56) Documents cités:
- US-A- 5 049 775
- US-A1- 2005 073 219
- US-A1- 2013 140 156

## Description

### DOMAINE TECHNIQUE

La présente invention concerne le domaine des microsystèmes mécaniques. De tels systèmes peuvent être définis comme des objets dont au moins une dimension caractéristique est micrométrique et qui sont aptes à se déformer localement. Ils sont configurés pour réaliser une fonction de capteur, c'est-à-dire pour transformer une grandeur physique, telle qu'une force et/ou une déformation, en signal électrique, et/ou, à l'inverse, pour réaliser une fonction d'actuateur, c'est-à-dire pour transformer un signal électrique en une grandeur physique, telle qu'une force et/ou une déformation. Le type de microsystèmes mécaniques concernés comprend plus particulièrement :
a. au moins une partie dite électroactive convertissant une force et/ou une déformation en signal électrique, et inversement, et
b. au moins une partie dite passive sur laquelle l'exercice d'une force et/ou d'une déformation est converti en signal électrique ou est commandé par application d'une tension électrique sur la partie électroactive.

Ces conversions peuvent se réaliser grâce à des phénomènes physiques tels que la dilatation, l'électrostriction, l'effet piézoélectrique, le changement d'état ou de phase, l'effet thermoélectrique, l'effet pyroélectrique, etc.

La présente invention trouve pour application particulièrement avantageuse son intégration dans des microsystèmes électromécaniques (ou MEMS), des systèmes électromécaniques nanométriques (ou NEMS), des transducteurs, des capteurs, des actuateurs, des micromembranes, des micropoutres, des micromoteurs, etc.

### ÉTAT DE LA TECHNIQUE

Actuellement, la réalisation de micropoutres ou de micromembranes connue consiste à déposer un matériau électroactif sur une couche flexible à base d'un matériau passif.

Plus particulièrement, sont connus des microsystèmes mécaniques comprenant :
a. Au moins deux poutres flexibles en un matériau dit passif, tel que du silicium,
b. Une charnière mécanique joignant lesdites au moins deux poutres entre elles, et
c. Au moins deux couches dites électroactives, chacune à base d'un matériau dit électroactif, par exemple un matériau piézoélectrique,
au moins une couche électroactive étant agencée sur chacune desdites au moins deux poutres.

Lorsque de tels microsystèmes mécaniques sont utilisés en tant qu'actuateurs, l'application d'une tension électrique entre des bornes d'une des couches électroactives induit la contraction ou l'allongement, suivant le sens de la polarisation électrique, de la poutre sur laquelle la couche électroactive est déposée. Ainsi, un effet bilame est créé.

Plus particulièrement, en absence d'application d'une tension, un tel microsystème mécanique présente sensiblement une symétrie planaire qu'il quitte pour prendre une symétrie courbée lorsqu'une tension électrique est appliquée. En effet, chaque poutre au niveau de laquelle une tension électrique est appliquée subit un déplacement la conduisant en dehors du plan dit de repos dans lequel le microsystème mécanique s'inscrit en absence d'application d'une tension.

Il est par ailleurs connu que les couches piézoélectriques à base de PZT (pour Titano-Zirconate de Plomb) présentent un intérêt en termes de facteurs de qualité et de rendement de conversion électrique-mécanique. Cependant, les couches électroactives ferroélectriques ne font que se contracter quel que soit le sens de la polarisation du champ électrique qui lui est appliqué. Dans ce cas, chaque poutre sur laquelle une tension électrique est appliquée se déplace toujours vers un même demi-espace défini par le plan de repos.

Pour que les déplacements hors plan des poutres puissent être générés dans les deux sens, il est possible de déposer, sur un même substrat, deux couches à base de PZT superposées entre elles et séparées d'une couche électrode de Pt/Ti (Cf. notamment « 2D scanning mirror using bi-layer PZT films », de J. Tsaur, et al., AIST, Tsukuba, Japan, 2D Micro Scanner Actuated by sol-gel derived double layered PZT, MEMS 2002). De la sorte, en appliquant une tension électrique uniquement sur une première des deux couches de PZT, on obtient un déplacement des poutres opposé à celui obtenu en appliquant une tension électrique uniquement sur la seconde des deux couches de PZT. Ainsi, les poutres sont propres à se déplacer dans les deux demi-espaces définis par le plan dans lequel s'inscrit sensiblement le microsystème mécanique en absence d'application d'une tension électrique. En outre, le procédé de formation d'un tel microsystème mécanique peut comprendre la gravure locale du substrat sur toute son épaisseur, de sorte que la fibre neutre d'un tel microsystème mécanique passe alors avantageusement entre les deux couches à base de PZT.

Il est toutefois très laborieux, dans l'état actuel de la technique, de réaliser une double série de déposition de PZT. On trouve des exemples de l'art antérieur dans les demandes US2013/140156, US2005/073219 et US5049775.

Un objet de la présente invention est donc de proposer un microsystème mécanique présentant au moins les mêmes avantages, et présentant notamment des éléments déformables aptes à se mouvoir dans au moins deux sens, qui soit de fabrication plus aisée et/ou moins coûteuse

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, l'invention concerne, selon un premier aspect, un microsystème comprenant :
a. une paire d'éléments déformables élastiquement,
b. une charnière mécanique joignant les éléments déformables entre eux, et
c. au moins deux couches électroactives,

le microsystème mécanique étant configuré de sorte que, depuis une position de repos dans laquelle les éléments déformables s'inscrivent sensiblement dans un même plan dit de repos, une déformation d'au moins l'un des éléments déformables le déplaçant au moins en partie hors du plan de repos induise une circulation de courant électrique dans au moins une des au moins deux couches électroactives, et/ou inversement,
chaque élément déformable présentant une face avant et une face arrière opposées l'une à l'autre et sensiblement parallèles au plan de repos,
le microsystème mécanique étant essentiellement tel qu'une première des au moins deux couches électroactives est agencée conjointement avec un premier élément déformable de la paire sur une face arrière de ce premier élément déformable, et en ce qu'une deuxième couche électroactive, différente de la première couche, des au moins deux couches électroactives est agencée avec un second élément déformable de la paire, différent du premier élément, sur une face avant de ce second élément déformable.

Les faces avant/arrière des éléments déformables présentent entre elles une même orientation opposée à l'orientation des faces arrière/avant des éléments déformables.

L'invention selon son premier aspect propose ainsi un microsystème mécanique apte à générer des mouvements, hors plan de repos, antagonistes des éléments déformables par la réalisation d'un effet bilame.

Grâce à ces mouvements antagonistes des éléments déformables, il est permis de générer un angle entre deux éléments déformables d'une même paire, c'est-à-dire au niveau d'une partie intermédiaire, dite charnière mécanique ou « rotule », du dispositif, qui est doublé par rapport à un microsystème mécanique à mouvements non antagonistes et/ou d'obtenir des déplacements des éléments déformables d'une même paire, d'une amplitude sensiblement égale à celle offerte par un microsystème mécanique à mouvements non antagonistes, mais en réalisant des économies d'énergie électrique et/ou d'obtenir une amplitude sensiblement supérieure à tension d'actuation équivalente.

En outre, la fibre neutre du microsystème mécanique selon le premier aspect de l'invention passe avantageusement entre chaque élément déformable et la couche électroactive agencée conjointement à cet élément déformable, permettant ainsi de maximiser l'effet bilame.

Un deuxième aspect de l'invention concerne un procédé de fabrication d'un microsystème mécanique comprenant :
a. Fournir un substrat, à base d'un premier matériau, sur une face avant duquel au moins une première couche électroactive et une deuxième couche électroactive sont formées, de préférence simultanément, de façon espacées entre elles, le substrat comprenant en outre une couche d'arrêt de gravure enterrée présentant une ouverture à l'aplomb d'au moins une partie de la première couche électroactive et de préférence exempte d'ouverture à l'aplomb de la deuxième couche électroactive,
b. Déposer une couche dite passive, à base d'un deuxième matériau, au moins à l'aplomb d'au moins une partie de la première couche électroactive, en laissant au moins une partie de la deuxième couche électroactive non recouverte de ladite couche passive,
c. Graver au moins une partie centrale du substrat par sa face arrière, jusqu'à retirer ladite au moins une partie centrale du substrat sur toute son épaisseur située à l'aplomb de la couche d'arrêt de gravure et jusqu'à retirer ladite au moins une partie centrale du substrat sur toute son épaisseur au droit de l'ouverture que présente la couche d'arrêt de gravure,
   de sorte que la couche passive forme un premier élément déformable élastiquement, agencé conjointement avec la première couche électroactive,
   de sorte que le substrat gravé forme un deuxième élément déformable élastiquement, agencé conjointement avec la deuxième couche électroactive, et
   de sorte que l'un au moins parmi le substrat gravé et la couche passive forme une charnière mécanique joignant entre eux les premier et deuxième éléments déformables.

Le procédé permet ainsi de fabriquer un microsystème mécanique offrant la fonction recherchée de façon aisée et/ou moins coûteuse, notamment du fait que les couches électroactives peuvent être déposées simultanément.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente schématiquement une vue en coupe du microsystème mécanique selon un mode de réalisation du premier aspect de l'invention ;
Les figures 2 à 7 représentent schématiquement différentes étapes du procédé de fabrication du microsystème mécanique tel qu'illustré sur la figure 1, chacune de ces représentations schématiques montrant une vue en coupe à différents stades de fabrication du microsystème mécanique ; et
La figure 8 représente schématiquement une vue en coupe du microsystème mécanique selon un mode de réalisation du premier aspect de l'invention dans son état hors repos.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs telles qu'illustrées des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

De manière facultative, le microsystème mécanique selon le premier aspect de l'invention peut en outre présenter au moins l'une quelconque des caractéristiques suivantes :
La charnière mécanique peut joindre les éléments déformables de chaque paire entre eux par l'une de leurs extrémités distales ;
Les éléments déformables de chaque paire peuvent être situés à l'opposé l'un de l'autre relativement à la charnière mécanique ;
De préférence, une unique couche électroactive est agencée conjointement avec chacun des éléments déformables ;
Le microsystème mécanique peut comprendre en outre un cadre rigide auquel les éléments déformables sont solidairement joints par des extrémités proximales, la charnière mécanique joignant les éléments déformables de la paire entre eux par leurs extrémités distales, et la charnière mécanique peut être flexible de sorte à permettre un mouvement des éléments déformables de la paire hors du plan de repos ;
Au moins une couche électroactive, de préférence chaque couche électroactive, est à base d'un matériau électroactif choisi parmi : un matériau piézoélectrique, un matériau ferromagnétique et un matériau à base de PTZ. Une liste non exhaustive de matériaux ferromagnétiques envisagés comprend par exemple la famille des perovskites ABO3, telles que PbZrTiO3 (PZT), PbMgNbTiO3 (PMNT), PbMgNbO3-PbTiO3 (PMN-PT), KNaNbO3 (KNN), BaSrTiO3 (BST), BaCaZrTiO3 (BCTZ), BaTiO3 (BT), NaBiTiO3 (NBT), NaBiTiO3-BaTiO3 (NBT-BT), BiFeO3, et les polymères ferromagnétiques tels que le poly(fluorure de vinylidène) (ou PVDF). Des matériaux piézoélectriques non ferromagnétiques sont également envisagé, tels que AIN, AIN dopé Sc, ZnO. Le microsystème mécanique avec des couches électroactives à base de PZT est particulièrement intéressant puisque ce type de couche électroactive présente un facteur de qualité et un rendement de conversion intéressant, mais, comme tous les matériaux ferroélectriques, ne peut que se contracter sous l'effet d'un champ électrique, et ne peut donc pas permettre de déformer l'élément déformable qui le supporte dans plus d'une direction ;
Les éléments déformables et la charnière mécanique peuvent être à base d'un même matériau, par exemple à base de silicium ;
Le microsystème mécanique peut comprendre en outre au moins une couche intermédiaire située entre la première couche électroactive et le premier élément déformable et/ou de part et/ou d'autre de ladite première couche électroactive et du premier élément déformable, et/ou située entre la deuxième couche électroactive et le deuxième élément déformable et/ou de part et/ou d'autre de ladite deuxième couche électroactive et du deuxième élément déformable. Ladite au moins une couche intermédiaire peut être configurée pour réaliser une reprise de contact électrique, notamment pour appliquer et/ou mesurer une circulation de courant électrique dans au moins l'une parmi la première et la deuxième couches électroactives avec laquelle ladite au moins une couche intermédiaire est conjointement agencée. En complément ou en alternative à la caractéristique précédente, ladite au moins une couche intermédiaire peut être agencée de sorte qu'une fibre neutre du microsystème mécanique se situe entre chaque couche électroactive et l'élément déformable agencé avec cette couche électroactive ;
Le microsystème mécanique peut comprendre en outre au moins une deuxième paire d'éléments déformables élastiquement. Les éléments déformables de ladite au moins une deuxième paire peuvent être joints entre eux par la charnière mécanique joignant entre les éléments déformables de la première paire ou par une charnière mécanique différente de la charnière mécanique joignant entre eux les éléments déformables de la première paire. En alternative ou en combinaison avec la caractéristique précédente, les paires d'éléments déformables peuvent être agencées selon une symétrie de rotation autour de la charnière mécanique. Dans l'absolu, le microsystème mécanique selon le premier aspect de l'invention peut en outre comprendre un ou plusieurs éléments déformables ne faisant pas partie d'une paire d'éléments déformables ;
L'un au moins des éléments déformables peut être choisi parmi : une poutre et une membrane ;
Les éléments déformables de chaque paire peuvent présenter sensiblement une même géométrie ;
La charnière mécanique peut comprendre au moins une structuration, notamment par retrait(s) de matière, de la zone du microsystème mécanique située entre les éléments déformables de chaque paire. Ladite au moins une structuration confère de préférence, à la charnière mécanique, une souplesse sensiblement plus élevée que celle caractérisant les éléments déformables, notamment lorsque le microsystème mécanique comprend un cadre rigide auquel les éléments déformables sont solidairement joints.

De manière facultative, le procédé de fabrication selon le deuxième aspect de l'invention peut en outre présenter au moins l'une quelconque des caractéristiques suivantes :
La formation des première et deuxième couches électroactives peut comprendre les étapes suivantes :
a. un unique dépôt d'un film en un matériau électroactif sur la face avant du substrat, puis
b. une gravure du film déposé, cette gravure mettant le cas échéant en oeuvre un masque de gravure, de sorte à dessiner et à séparer entre elles les première et deuxième couches électroactives.

Notons que si les première et deuxième couches électroactives sont ainsi réalisées simultanément via un unique dépôt du film en un matériau électroactif, le dépôt dudit film peut en lui-même comprendre un certain nombre d'étapes, et donc être relativement laborieuse. Ceci illustre l'intérêt que revêt l'invention sur l'état de la technique dont il est fait mention en introduction de la demande, selon lequel un double dépôt de films en matériau électroactif est à réaliser, qui est plus que doublement fastidieux relativement au dépôt unique du procédé selon la caractéristique ci-dessus.

Seule la partie centrale du substrat peut être gravée de sorte que le pourtour restant du substrat forme un cadre rigide auquel les éléments déformables sont solidairement joints par leurs extrémités proximales, la charnière mécanique joignant les éléments déformables entre eux par leurs extrémités distales, et la charnière mécanique peut être flexible de sorte à permettre un mouvement de chaque élément déformable hors du plan de repos. Le procédé de fabrication peut comprendre en outre une étape de structuration de la charnière mécanique, notamment par au moins un retrait de matière, de la zone du substrat et/ou de la couche passive située entre les éléments déformables. Ladite au moins une structuration est de préférence paramétrée de sorte que la charnière mécanique présente une souplesse plus élevée que celle caractérisant les éléments déformables au moins dans une direction donnée ;

Le procédé de fabrication peut comprendre en outre le dépôt d'au moins une couche intermédiaire située entre la première couche électroactive et le premier élément déformable et/ou de part et/ou d'autre de ladite première couche électroactive et du premier élément déformable, et/ou située entre la deuxième couche électroactive et le deuxième élément déformable et/ou de part et/ou d'autre de ladite deuxième couche électroactive et du deuxième élément déformable. Le dépôt de ladite au moins une couche intermédiaire est le cas échéant paramétré pour réaliser une reprise de contact électrique, notamment pour appliquer et/ou mesurer une circulation de courant électrique dans la couche électroactive avec laquelle ladite au moins une couche intermédiaire est conjointement agencée ;

Le dépôt de la couche passive est paramétré de sorte que la couche passive présente une épaisseur sensiblement égale à la profondeur à laquelle la couche d'arrêt de gravure est enterrée dans le substrat depuis sa face avant. Le procédé permet ainsi de conférer aux éléments déformables de chaque paire sensiblement une même géométrie. De la sorte, une même amplitude de déformation de chaque élément déformable d'une paire peut être escomptée suite à l'application d'un même courant électrique à chacune des couches électroactives conjointement agencées avec lesdits éléments déformables, ou la mesure d'un même courant électrique circulant dans chacune des couches électroactives peut être escomptée suite à une même amplitude de déformation desdits éléments déformables.

On entend par un film à base d'un matériau A, un film comprenant ce matériau A et éventuellement d'autres matériaux.

Il est précisé que dans le cadre de la présente invention, le terme « électroactif » et ses dérivés désignent la qualité d'un élément qui a, dans le cadre de la présente invention, vocation à servir d'élément apte à convertir en signal électrique en une variation de grandeur physique, et/ou inversement. Cette conversion peut être réalisée par piézoélectricité, par différence de dilatation thermique, par électrostriction, etc.

Il est précisé que dans le cadre de la présente invention, le terme « passif » et ses dérivés désignent la qualité d'un élément fait à base d'un matériau qui n'a pas, dans le cadre de la présente invention, de vocation à servir d'élément électroactif.

On entend par « fibre neutre » une ligne ou surface située à l'intérieur d'une pièce déformée, par exemple pliée ou cintrée, sur laquelle ne s'exerce ni contraintes de traction, ni contraintes de compression. Plus particulièrement, lors d'une flexion d'une poutre ou d'une membrane sous l'effet d'une force, la raideur des matériaux fait qu'il apparait une contrainte mécanique en surface qui diminue dans l'épaisseur jusqu'à changer de signe sur la surface opposée. Il y a donc une surface fictive dans le matériau où cette contrainte est nulle. Cette surface est définie comme étant la fibre neutre d'un côté de laquelle les matériaux sont en compression et de l'autre côté de laquelle les matériaux sont en tension.

On entend par « poutre » un élément déformable de forme allongée, éventuellement courbé, voire plié, dont on utilise la déformation, de préférence élastique, comme actuateur ou comme capteur.

On entend par « membrane » un élément déformable comprenant une paroi souple dont on utilise la déformation, de préférence élastique, comme actuateur ou comme capteur.

On entend par « charnière mécanique » une région d'articulation mécanique au moins entre deux éléments déformables d'une même paire.

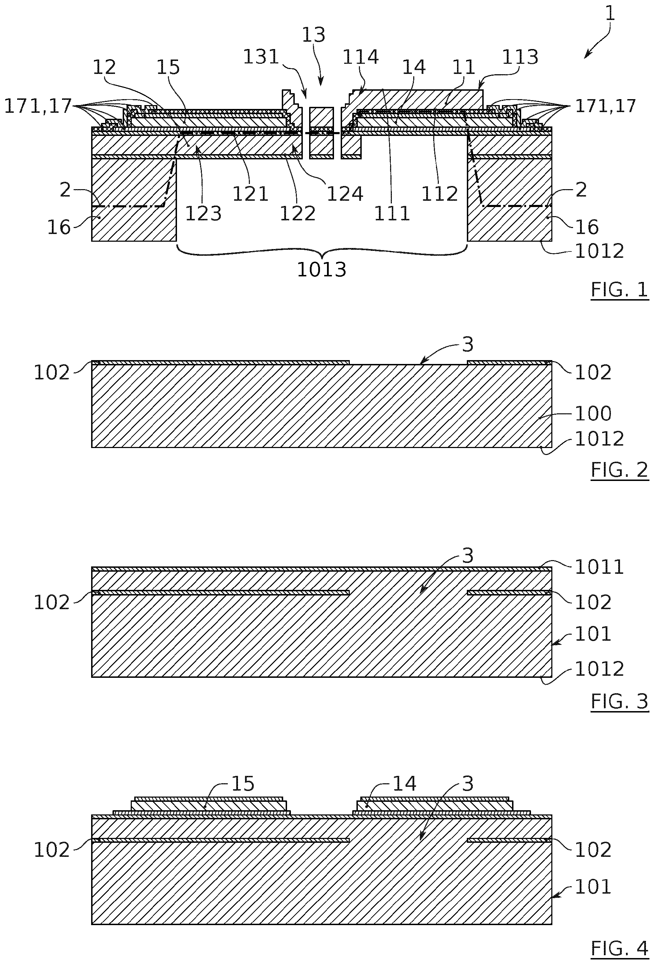

Un mode de réalisation préféré du deuxième aspect de l'invention va d'abord être décrit de façon détaillée ci-dessous en référence aux figures 2 à 7.

Le deuxième aspect de l'invention concerne un procédé de fabrication d'un microsystème mécanique 1 selon le premier aspect de l'invention.

Le procédé de fabrication comprend tout d'abord une étape consistant à fournir un substrat 101. Le substrat 101 est à base d'un premier matériau. Le premier matériau est un matériau dit passif. Il s'agit par exemple de silicium, et de préférence de silicium monocristallin. Plus particulièrement, le substrat 101 comprend ou est constitué d'une tranche de silicium (ou wafer selon la terminologie anglo-saxonne).

Sur la face avant 1011 du substrat 101 fourni, au moins une première couche électroactive 14 et une deuxième couche électroactive 15 sont formées qui sont espacées entre elles. Les première et deuxième couches électroactives 14 et 15 forment une paire. Elles forment plus généralement une première paire de couches électroactives, le substrat 101 tel que fourni pouvant comprendre une pluralité de paires de couches électroactives.

En outre, le substrat 101 comprend une couche d'arrêt de gravure 102 enterrée. Nous verrons plus bas que la profondeur à laquelle la couche d'arrêt de gravure 102 est enterrée dans le substrat 101 peut avoir une influence sur le comportement du microsystème mécanique 1 fabriqué.

La couche d'arrêt de gravure 102 comprend une ouverture 3 dans l'étendue de sa surface. L'ouverture 3 est plus particulièrement située à l'aplomb, ou au droit, d'au moins une partie de la première couche électroactive 14. De préférence, l'ouverture 3 de la couche d'arrêt de gravure 102 ne s'étend pas sous la deuxième couche électroactive 15. Plus particulièrement, la couche d'arrêt de gravure est de préférence exempte d'ouverture à l'aplomb de la deuxième couche électroactive 15.

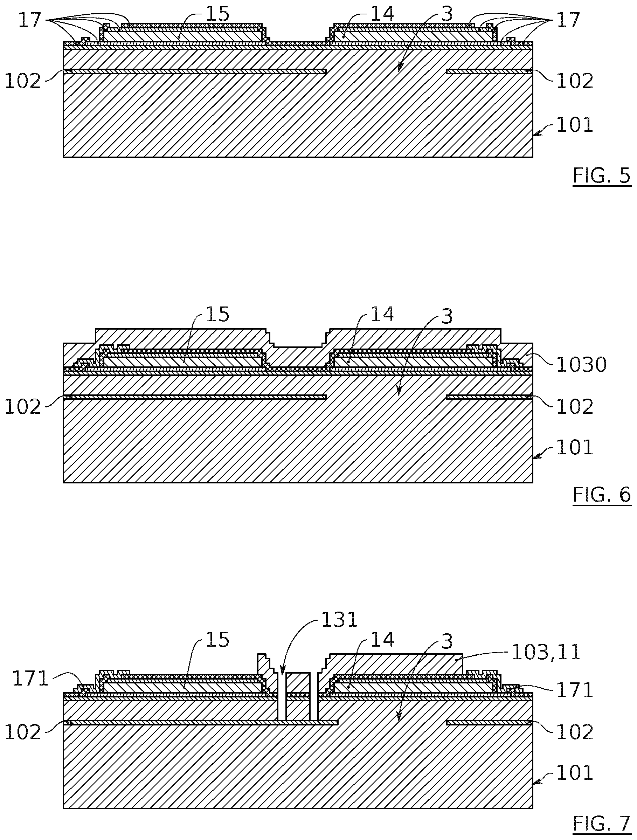

Cette première étape du procédé selon le mode de réalisation préféré du deuxième aspect de l'invention consiste donc à fournir un empilement de couches d'épaisseurs micrométriques tel qu'illustré sur l'une quelconque des figures 4 et 5.

Cette première étape du procédé selon le mode de réalisation préféré du deuxième aspect de l'invention peut plus particulièrement comprendre, comme cela est illustré sur les figures 2 à 6, les sous-étapes suivantes :
a. fournir une tranche de silicium 100 ;
b. générer, par exemple par oxydation directe du silicium dans un four sous atmosphère et pression contrôlées, une couche d'oxyde de silicium sur la face avant de la tranche, en tant que couche d'arrêt de gravure 102 ;
c. pratiquer, par exemple par un procédé de gravure chimique au travers d'un masque réalisé par lithographie ou par gravure ionique réactive, une ouverture dans la couche d'oxyde de silicium 102 générée, en tant qu'ouverture 3 telle que décrite ci-dessus. L'empilement obtenu alors est tel qu'illustré sur la figure 2 ;
d. déposer, par exemple par dépôt chimique en phase vapeur, une couche de silicium, potentiellement amorphe, sur la couche d'oxyde de silicium 102 et sur l'ouverture 3, de préférence sur toute l'étendue de la tranche de silicium 100. Cette couche de silicium est de préférence déposée de sorte à présenter une surface avant sensiblement plane. La couche de silicium est de préférence déposée sur l'ouverture 3 avant que le silicium à nu de la tranche de silicium 100 ne se soit oxydée ;
e. Générer, par exemple par dépôt chimique en phase vapeur assisté par plasma (ou PECVD pour *pressure enhanced chemical vapour deposition* en anglais), une couche d'oxyde de silicium en surface de la couche de silicium précédemment déposée. L'empilement obtenu alors est tel qu'illustré sur la figure 3 ;
f. déposer, sur la couche de silicium précédemment déposée et oxydée en surface, au moins un film à base d'un matériau électroactif destiné à constituer chacune des couches électroactives 14 et 15 introduites ci-dessus. De préférence, un unique film à base d'un matériau électroactif est déposé à cette étape. L'on évite ainsi le travail fastidieux que constitue la déposition d'une bicouche à base d'au moins un matériau électroactif. Cette étape de dépôt peut comprendre également le dépôt, par exemple par dépôt physique en phase vapeur, d'une couche conductrice d'électricité supérieure et d'une couche conductrice d'électricité inférieure, par exemple à base de platine, situées de part et d'autre de la couche à base du matériau électroactif. Chacune de ces couches conductrices est destinée à constituer autant d'électrodes que le microsystème mécanique compte de couches électroactives ;
g. Graver au moins la couche à base d'un matériau électroactif, et le cas échéant graver également, les couches conductrices, de sorte à former, sur la face avant 1011 du substrat 101, au moins les deux couches électroactives 14 et 15, le cas échéant chacune étant prise en sandwich entre les électrodes formées par gravure des couches conductrices. L'empilement obtenu alors est tel qu'illustré sur la figure 4;
h. déposer et éventuellement graver certaines autres couches destinées à permettre soit d'isoler, soit au contraire de connecter, électriquement entre elles certaines couches ou portion de couches, notamment par leurs bords, et à constituer au moins des reprises de contact 171. L'empilement obtenu alors est tel qu'illustré sur la figure 5.

Par les reprises de contact 171, du courant électrique peut ainsi avantageusement être soit injecté dans, soit collecté depuis, les couches électroactives 14 et 15 via leurs électrodes respectives.

Les électrodes et le cas échéant les reprises de contact 171 sont ici considérées comme autant de couches intermédiaires 17 dont le mode de réalisation préféré du procédé selon le deuxième aspect de l'invention prévoit le dépôt. Il ressort de ce qui précède qu'au moins une de ces couches intermédiaires 17 peut être située entre l'une ou l'autre parmi les première et deuxième couches électroactives 14, 15 et le substrat 101 sous-jacent, ou au moins sur l'une au moins parmi les première et deuxième couches électroactives, ou de part et d'autre des première et deuxième couches électroactives.

Une fois obtenu un empilement de couches d'épaisseurs micrométriques tel qu'illustré sur l'une ou l'autre des figures 4 et 5, le procédé de fabrication selon le mode de réalisation préféré du deuxième aspect de l'invention comprend le dépôt d'une couche dite passive 103 formée à base d'un deuxième matériau. La couche 103 est dite passive car plus particulièrement formée à base d'un matériau dit passif.

Le deuxième matériau à base duquel la couche passive 103 est formée peut être de même nature que le premier matériau à base duquel le substrat 101 est formé. Ainsi, selon le mode de réalisation préféré de l'invention, la couche passive 103 telle que déposée est à base de silicium, de préférence polycristallin.

L'étape de dépôt de la couche passive 103 est plus particulièrement réalisée au moins à l'aplomb d'au moins une partie de la première couche électroactive 14, mais de sorte à laisser au moins une partie de la deuxième couche électroactive 15 non recouverte.

Cette deuxième étape du procédé selon le mode de réalisation préféré du deuxième aspect de l'invention peut plus particulièrement comprendre, comme cela est illustré sur les figures 6 et 7, les sous-étapes suivantes :
a. déposer une couche 1030, de préférence conforme, de silicium, de préférence polycristallin, sur l'empilement de couches fournies à la première étape du procédé ; et
b. graver cette couche 1030 au moins à l'aplomb d'au moins une partie de la deuxième couche électroactive 15. De préférence, cette sous-étape de gravure comprend en outre la gravure de la couche conforme à l'aplomb des reprises de contact 171. De préférence encore, cette sous-étape de gravure comprend en outre la gravure de la partie de la couche conforme, voire du substrat 101 sous-jacent, située au milieu des première et deuxième couches électroactives 14 et 15. La gravure du substrat 101 peut alors comprendre la traversée de la couche d'oxyde de silicium préalablement générée en surface de la couche de silicium située sur la couche d'arrêt de gravure 102. Cette sous-étape de gravure a pour objectif de former un premier élément déformable 11 élastiquement au moins sur au moins une partie de la première couche électroactive 14, mais a de préférence également pour objectif de structurer la zone située au centre du substrat 101, au milieu des première et deuxième couches électroactives 14 et 15, de sorte à former une charnière mécanique 13 par structuration du substrat 101. Cette structuration peut notamment être réalisée au moyen d'au moins un retrait de matière 131. Ce retrait de matière 131 formé de la façon illustrée sur la figure 7 peut consister en un trou ou une tranchée, de préférence borgne, s'étendant par exemple depuis la face avant du microsystème mécanique 1 jusqu'à la couche d'arrêt de gravure 102 enterrée.

La charnière mécanique 13 ainsi formée est d'une souplesse maîtrisée. Elle peut plus particulièrement être configurée pour présenter une souplesse plus importante que la souplesse du premier élément déformable 11.

Notons ici que le dépôt de la couche passive 103 est de préférence paramétré de sorte que cette couche présente une épaisseur sensiblement égale à l'épaisseur de la couche de silicium préalablement déposée sur la couche d'oxyde de silicium 102 et sur l'ouverture 3. Autrement dit, le dépôt de la couche passive 103 est de préférence paramétré de sorte que cette couche présente une épaisseur sensiblement égale à la profondeur à laquelle la couche d'arrêt de gravure 102 est enterrée dans le substrat 101 depuis sa face avant 1011.

Le procédé de fabrication comprend ensuite une étape consistant à graver au moins en partie le substrat 101 depuis sa face arrière 1012. Plus particulièrement, au moins une partie centrale 13 du substrat 100 est gravée au cours de cette étape. Cette étape de gravure est paramétrée de sorte à retirer la partie centrale 1013 du substrat 100 sur toute son épaisseur située à l'aplomb de la couche d'arrêt de gravure 102. Elle est en outre paramétrée de sorte à se poursuivre par le retrait de la partie centrale 1013 du substrat 101 sur toute son épaisseur au droit de l'ouverture 3 que présente la couche d'arrêt de gravure 102. Plus particulièrement, la poursuite de la gravure au droit de l'ouverture 3 est avantageusement stoppée par la couche d'oxyde de silicium générée en surface de la couche passive 103.

L'on obtient ainsi un microsystème mécanique 1 tel qu'illustré à titre exemplatif sur la figure 1. Plus particulièrement, tel qu'illustré sur la figure 1, l'étape de gravure du substrat 100 par sa face arrière 1012 permet de former un deuxième élément déformable 12 élastiquement, agencé conjointement avec la deuxième couche électroactive 15.

Il est à noter que, en alternative ou en complément, la structuration de la charnière mécanique 13 telle que décrite ci-dessus, l'étape de gravure du substrat 101 par sa face arrière 1012 peut être paramétrée de sorte à contribuer à la structuration de la charnière mécanique 13.

Il apparaît, sur la figure 1, que la charnière mécanique 13 formée de la façon décrite ci-dessus permet de joindre entre eux les éléments déformables 11 et 12.

De préférence, seule la partie centrale du substrat 101 est gravée depuis la face arrière 1012 du substrat 101. Ainsi, tel qu'illustré sur la figure 1, le pourtour intérieur du substrat 101 n'est pas gravé et est conservé de sorte à constituer un cadre 16 rigide auquel les éléments déformables 11,12 sont solidairement joints. Les éléments déformables 11,12 sont plus particulièrement solidairement joints au cadre 16 par leurs extrémités proximales 113,123, tandis que la charnière mécanique 13 joint entre eux les éléments déformables 11,12 par leurs extrémités distales 114,124. L'on comprend donc que, dans ce mode de réalisation préféré, il est avantageux que la charnière mécanique 13 soit flexible, de sorte à permettre un mouvement de chaque élément déformable 11,12 hors du plan de repos dans lequel chaque élément déformable 11,12 s'inscrit comme suite à la mise en oeuvre du procédé de fabrication selon le deuxième aspect de la présente invention. En effet, les extrémités proximales 113,123 des éléments déformables 11,12 étant joints au cadre 16 rigide ne sont pas amenés à se déformer de façon significative par rapport à la déformation que peut subir chacune des extrémités distales 114,124 des éléments déformables 11,12 dans la mesure où ceux-ci sont joints à la charnière mécanique 13 qui est relativement plus souple que le cadre 16 rigide, voire relativement plus souple que les éléments déformables 11,12 eux-mêmes.

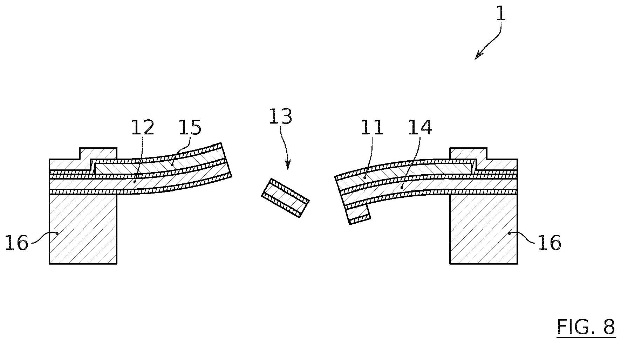

En référence à la figure 8, chacun des éléments déformables 11 et 12 ayant des mouvements antagonistes, du fait de la disposition détaillée plus bas des couches électroactives 14,15 vis-à-vis des éléments déformables 11,12, les mouvements antagonistes, hors de leur plan de repos, des éléments déformables 11, 12 induisent, par construction, une rotation de la charnière mécanique 13 autour d'un centre de rotation s'inscrivant sensiblement dans le plan de repos. La charnière mécanique 13 constitue ainsi une zone potentiellement soumise à une rotation suivant un axe inscrit dans le plan de repos, cette rotation pouvant varier autour d'une position d'équilibre qui reste sensiblement dans le plan de repos. Là encore, par rapport à l'état de l'art, le fait de disposer d'une capacité de rotation de la charnière mécanique 13 qui oscille par rapport à une position d'équilibre située dans le plan de repos, permet d'obtenir des rotations à des tensions de moitié moindre, ce qui présente un intérêt certain.

Les différentes étapes et sous-étapes de dépôt et de gravure susmentionnées sont avantageusement mises en œuvre par des techniques standards de la micro-électronique, telles que des dépôts physiques ou chimiques en phase vapeur, des gravures ioniques réactives ou des gravures chimiques. Ces techniques peuvent éventuellement nécessiter de mettre en œuvre des masques de gravure et/ou comprendre des étapes de dépôt de passivation.

Il apparaît également, que, des suites du procédé de fabrication selon son mode de réalisation préféré décrit ci-dessus, les éléments déformables 11,12 constituent des poutres faites d'un même matériau passif, à savoir du silicium, de préférence polycristallin, et présentant sensiblement la même épaisseur, voire la même géométrie.

De la sorte, une même amplitude de déformation de chaque élément déformable 11, 12 d'une paire peut être escomptée suite à l'application d'un même courant électrique à chacune des couches électroactives 14,15 conjointement agencées avec lesdits éléments déformables 11,12, ou la mesure d'un même courant électrique circulant dans chacune des couches électroactives 14,15 peut être escomptée suite à une même amplitude de déformation desdits éléments déformables 11,12.

En outre, il apparaît que la charnière mécanique 13 est au moins en partie constituée à base du même matériau que les éléments déformables 11,12, la charnière mécanique 13 étant en effet obtenu par structuration du substrat 101 à base de silicium.

En référence à la figure 1, le microsystème mécanique 1 selon le premier aspect de l'invention comprend donc essentiellement :
a. une paire d'éléments déformables 11,12 élastiquement,
b. une charnière mécanique 13 joignant les éléments déformables 11, 12 entre eux, et
c. au moins deux couches électroactives 14, 15,

le microsystème mécanique 1 étant configuré de sorte que, depuis une position de repos dans laquelle les éléments déformables 11, 12 s'inscrivent sensiblement dans le plan de repos susmentionné, une déformation des éléments déformables 11, 12 les déplaçant au moins en partie hors du plan de repos induise une circulation de courant électrique dans les couches électroactives 14, 15, et/ou inversement.

On notera que, par construction, chaque élément déformable 11, 12 présente une face avant 111, 121 et une face arrière 112, 122 opposées l'une à l'autre et sensiblement parallèles au plan de repos.

Le microsystème mécanique 1 se distingue des microsystèmes mécaniques connus de l'art antérieur au moins en ce que la première couche électroactive 14 est agencée conjointement avec le premier élément déformable 11 de la paire sur une face arrière 112 de ce premier élément déformable 11, et en ce que la deuxième couche électroactive 15 est agencée avec le second élément déformable 12 de la paire sur une face avant 121 de ce second élément déformable 12.

L'invention selon son premier aspect propose ainsi un microsystème mécanique 1 apte à générer des mouvements, hors plan de repos, antagonistes des éléments déformables 11, 12 de chaque paire pour réaliser un effet bilame, comme cela est représenté sur la figure 8. En effet, chacun des éléments déformables d'une même paire peut :
a. soit être déplacé dans un sens opposé à l'autre élément déformable de la paire pour induire la circulation d'un courant électrique dans la couche électroactive qu'il supporte, le microsystème mécanique agissant alors comme capteur,
b. soit être alimenté par un courant électrique pour induire son déplacement hors du plan de repos dans un sens opposé au déplacement hors du plan de repos de l'autre élément déformable de la paire, le microsystème mécanique agissant alors comme actuateur.

Grâce à ces mouvements antagonistes des éléments déformables 11, 12 de chaque paire, il est permis de générer un angle entre deux éléments déformables d'une même paire, suivant un axe dans le plan de repos, doublé, par rapport à un microsystème mécanique à mouvements non antagonistes, pour un même courant électrique circulant dans les couches électroactives. En regard de cet avantage, il est permis, grâce aux mouvements antagonistes des éléments déformables, d'obtenir des déplacements des éléments déformables 11, 12 d'une même paire, d'une amplitude sensiblement égale à celle offerte par un microsystème mécanique à mouvements non antagonistes, mais pour un courant électrique de moitié moindre, cet avantage traduisant des économies d'énergie électrique présentant un intérêt certain.

En outre, la fibre neutre du microsystème mécanique 1 selon le premier aspect de l'invention passe avantageusement entre chaque élément déformable 11, 12 et la couche électroactive 14, 15 agencée conjointement avec cet élément déformable. Cette position de la fibre neutre est une conséquence directe du procédé de fabrication 1, notamment lorsque celui-ci ne comprend pas de dépôt de couches intermédiaires 17. Lorsque le procédé comprend des dépôts de telles couches intermédiaires 17, ceux-ci sont paramétrés de sorte à ne pas influer significativement sur la position de la fibre neutre, de sorte que cette dernière continue de passer entre chaque élément déformable 11,12 et la couche électroactive 14,15 qui permet de le déformer, et donc de sorte que l'effet bilame désiré soit atteint.

Ces propriétés et avantages du microsystème mécanique 1 selon le premier aspect de l'invention sont particulièrement utiles lorsque l'on souhaite réaliser des miroirs MOEMS (pour « Micro-Opto-Electro-Mechnical Sytems » selon la terminologie anglo-saxonne), notamment pour faire du routage de télécommunications optiques ou des scanners pour dispositifs LIDAR.

Outre son application aux miroirs MOEMS, la présente invention trouve également à s'appliquer pour l'impression par jets d'encre, pour capter et mesurer une pression, etc.

Comme illustré sur la figure 1, les éléments déformables 11,12 sont situés à l'opposé l'un de l'autre relativement à la charnière mécanique 13. Cette dernière peut par ailleurs servir à joindre entre eux des éléments déformables (non représentés) d'une autre paire. Cette autre paire peut par exemple être identique à la paire d'éléments déformables 11, 12, mais en étant tournée de 90° autour de la charnière mécanique 13 par rapport à la paire d'éléments déformables 11,12. Autrement dit, la même illustration du microsystème mécanique 1 que celle de la figure 1 pourrait être obtenue en considérant un plan de coupe sensiblement centré sur la charnière mécanique 13 et perpendiculaire au plan de coupe qu'illustre la figure 1.

Il est à noter en outre que, si les poutres 11,12 apparaissent comme des éléments longilignes sur la figure 1, ces éléments peuvent adopter toute forme de géométrie sensiblement allongée. Ils peuvent par exemple être courbés, voire pliés, dans le plan de repos. Plus particulièrement, chaque poutre peut prendre n'importe quelle forme sensiblement allongée, et notamment les formes que prennent les poutres illustrées et décrites dans l'article de J. Tsaur, et al. référencé en introduction.

Le microsystème mécanique 1 selon le mode de réalisation préféré du premier aspect de l'invention comprend plus particulièrement des couches électroactives à base de PTZ. Le microsystème mécanique 1 avec ces couches électroactives 14, 15 est particulièrement intéressant puisque ce type de couche électroactive ne peut que se contracter sous l'effet d'un champ électrique, et ne peut donc pas permettre de déformer l'élément déformable 11, 12 qui le supporte dans plus d'une direction. C'est donc ici uniquement l'agencement particulier de chaque paire de couches électroactives avec chaque paire d'éléments déformables qui permet au microsystème mécanique 1 des mouvements antagonistes de ses éléments déformables. Par ailleurs, le PTZ présente avantageusement un taux de conversion piézoélectrique élevé.

L'invention n'est pas limitée aux modes de réalisations précédemment décrits et s'étend à tous les modes de réalisation couverts par les revendications.

Par exemple, chaque élément déformable, chaque paire d'éléments déformables, voire un ensemble d'éléments déformables, peut comprendre, ou constituer, ou être agencé conjointement avec, une membrane souple.

## Revendications

1. Microsystème mécanique (1) comprenant :
a. une paire d'éléments déformables (11, 12) élastiquement,
b. une charnière mécanique (13) joignant les éléments déformables (11, 12) entre eux, et
c. au moins deux couches électroactives (14, 15),
le microsystème mécanique (1) étant configuré de sorte que, depuis une position de repos dans laquelle les éléments déformables (11, 12) s'inscrivent sensiblement dans un même plan dit de repos, une déformation d'au moins l'un des éléments déformables (11, 12) le déplaçant au moins en partie hors du plan de repos induise une circulation de courant électrique dans au moins une des au moins deux couches électroactives (14, 15), et/ou inversement,
chaque élément déformable (11, 12) présentant une face avant (111, 121) et une face arrière (112, 122) opposées l'une à l'autre et sensiblement parallèles au plan de repos,
le microsystème mécanique (1) étant **caractérisé en ce qu'**une première (14) des au moins deux couches électroactives (14, 15) est agencée conjointement avec un premier élément déformable (11) de la paire sur une face arrière (112) de ce premier élément déformable (11), et **en ce qu'**une deuxième couche électroactive (15), différente de la première couche (14), des au moins deux couches électroactives (14, 15) est agencée avec un second élément déformable (12) de la paire, différent du premier élément (11), sur une face avant (121) de ce second élément déformable (12).

2. Microsystème mécanique (1) selon la revendication précédente, comprenant en outre un cadre rigide (16) auquel les éléments déformables (11, 12) sont solidairement joints par des extrémités proximales (113, 123), la charnière mécanique (13) joignant les éléments déformables (11, 12) de la paire entre eux par leurs extrémités distales (114, 124), et dans lequel la charnière mécanique (13) est flexible de sorte à permettre un mouvement des éléments déformables (11, 12) de la paire hors du plan de repos.

3. Microsystème mécanique (1) selon l'une quelconque des revendications précédentes, dans lequel au moins une couche électroactive (14, 15), de préférence chaque couche électroactive (14, 15), est à base d'un matériau électroactif choisi parmi : un matériau piézoélectrique, un matériau ferromagnétique et un matériau électroactif à base de PTZ.

4. Microsystème mécanique (1) selon l'une quelconque des revendications précédentes, dans lequel les éléments déformables (11, 12) et la charnière mécanique (13) sont à base d'un même matériau, par exemple à base de silicium.

5. Microsystème mécanique (1) selon l'une quelconque des revendications précédentes, comprenant en outre au moins une couche intermédiaire (17) située entre la première couche électroactive (14) et le premier élément déformable (11) et/ou de part et/ou d'autre de ladite première couche électroactive (14) et du premier élément déformable (11), et/ou située entre la deuxième couche électroactive (15) et le deuxième élément déformable (12) et/ou de part et/ou d'autre de ladite deuxième couche électroactive (15) et du deuxième élément déformable (12).

6. Microsystème mécanique (1) selon la revendication précédente, dans lequel ladite au moins une couche intermédiaire (17) est configurée pour réaliser une reprise de contact électrique, notamment pour appliquer et/ou mesurer une circulation de courant électrique dans au moins l'une parmi la première et la deuxième couches électroactives (14, 15) avec laquelle ladite au moins une couche intermédiaire (17) est conjointement agencée.

7. Microsystème mécanique (1) selon l'une quelconque des deux revendications précédentes, dans lequel ladite au moins une couche intermédiaire (17) est agencée de sorte qu'une fibre neutre (2) du microsystème mécanique (1) se situe entre chaque couche électroactive (14, 15) et l'élément déformable (11, 12) agencé avec cette couche électroactive (14, 15).

8. Microsystème mécanique (1) selon l'une quelconque des revendications précédentes, comprenant en outre au moins une deuxième paire d'éléments déformables élastiquement, les éléments déformables de ladite au moins une deuxième paire étant joints entre eux par la charnière mécanique joignant entre les éléments déformables (11, 12) de la première paire ou par une charnière mécanique différente de la charnière mécanique joignant entre eux les éléments déformables (11, 12) de la première paire.

9. Procédé de fabrication d'un microsystème mécanique (1) comprenant :
a. Fournir un substrat (101), à base d'un premier matériau, sur une face avant (1011) duquel au moins une première couche électroactive (14) et une deuxième couche électroactive (15) sont formées de façon espacées entre elles, le substrat (101) comprenant en outre une couche d'arrêt de gravure (102) enterrée présentant une ouverture (3) à l'aplomb d'au moins une partie de la première couche électroactive (14),
b. Déposer une couche dite passive (103), à base d'un deuxième matériau, au moins à l'aplomb d'au moins une partie de la première couche électroactive (14), en laissant au moins une partie de la deuxième couche électroactive (15) non recouverte de ladite couche passive (103),
c. Graver au moins une partie centrale (1013) du substrat (101) par sa face arrière (1012), jusqu'à retirer ladite au moins une partie centrale (1013) du substrat (101) sur toute son épaisseur située à l'aplomb de la couche d'arrêt de gravure (102) et jusqu'à retirer ladite au moins une partie centrale (1013) du substrat (101) sur toute son épaisseur au droit de l'ouverture (3) que présente la couche d'arrêt de gravure (102),
de sorte que la couche passive (103) forme un premier élément déformable (11) élastiquement, agencé conjointement avec la première couche électroactive (14),
de sorte que le substrat (101) gravé forme un deuxième élément déformable (12) élastiquement, agencé conjointement avec la deuxième couche électroactive (15), et
de sorte que l'un au moins parmi le substrat (101) gravé et la couche passive (103) forme une charnière mécanique (13) joignant entre eux les premier et deuxième éléments déformables (11, 12).

10. Procédé de fabrication selon la revendication précédente, dans lequel la formation des première et deuxième couches électroactives (14, 15) comprend les étapes suivantes :
a. un unique dépôt d'un film en un matériau électroactif sur la face avant (1011) du substrat (101), puis
b. une gravure du film déposé, cette gravure mettant le cas échéant en œuvre un masque de gravure, de sorte à dessiner et à séparer entre elles les première et deuxième couches électroactives (14, 15).

11. Procédé de fabrication selon l'une quelconque des deux revendications précédentes, dans lequel seule la partie centrale (1013) du substrat (101) est gravée de sorte que le pourtour restant du substrat forme un cadre (16) rigide auquel les éléments déformables (11, 12) sont solidairement joints par leurs extrémités proximales (113, 123), la charnière mécanique (13) joignant les éléments déformables (11, 12) entre eux par leurs extrémités distales (114, 124), et dans lequel la charnière mécanique (13) est flexible de sorte à permettre un mouvement de chaque élément déformable (11, 12) hors du plan de repos.

12. Procédé de fabrication selon la revendication précédente, comprenant en outre une étape de structuration de la charnière mécanique (13), notamment par au moins un retrait de matière (131), de la zone du substrat (101) et/ou de la couche passive (103) située entre les éléments déformables (11, 12).

13. Procédé de fabrication selon l'une des quatre revendications précédentes, comprenant en outre le dépôt d'au moins une couche intermédiaire (17) située entre la première couche électroactive (14) et le premier élément déformable (11) et/ou de part et/ou d'autre de ladite première couche électroactive (14) et du premier élément déformable (11), et/ou située entre la deuxième couche électroactive (15) et le deuxième élément déformable (12) et/ou de part et/ou d'autre de ladite deuxième couche électroactive (15) et du deuxième élément déformable (12).

14. Procédé selon la revendication précédente, dans lequel le dépôt de ladite au moins une couche intermédiaire (17) est paramétré pour réaliser une reprise de contact électrique, notamment pour appliquer et/ou mesurer une circulation de courant électrique dans la couche électroactive (14, 15) avec laquelle ladite au moins une couche intermédiaire (17) est conjointement agencée.

15. Procédé selon l'une quelconque des cinq revendications précédentes, dans lequel le dépôt de la couche passive (103) est paramétré de sorte que la couche passive (103) présente une épaisseur sensiblement égale à la profondeur à laquelle la couche d'arrêt de gravure (102) est enterrée dans le substrat (101) depuis sa face avant (1011).

## Patentansprüche

1. Mechanisches Mikrosystem (1), umfassend:
a. ein Paar von elastisch verformbaren Elementen (11, 12),
b. ein mechanisches Gelenk (13), das die verformbaren Elemente (11, 12) miteinander verbindet, und
c. mindestens zwei elektroaktive Schichten (14, 15),
wobei das mechanische Mikrosystem (1) konfiguriert ist, so dass aus einer Ruheposition, in der die verformbaren Elemente (11, 12) im Wesentlichen in derselben, so genannten Ruheebene in Verbindung stehen, eine Verformung von mindestens einem der verformbaren Elemente (11, 12), die dieses zumindest partiell aus der Ruheebene heraus verlagert, eine elektrischen Stromfluss in mindestens einer von den mindestens zwei elektroaktiven Schichten (14, 15) induziert, und/oder umgekehrt,
wobei jedes verformbare Element (11, 12) eine Vorderseite (111, 121) und eine Rückseite (112, 122) aufweist, die zueinander entgegengesetzt sind und im Wesentlichen parallel zu der Ruheebene sind,
wobei das mechanische Mikrosystem (1) **dadurch gekennzeichnet ist, dass** eine erste (14) von den mindestens zwei elektroaktiven Schichten (14, 15) zusammen mit einem ersten verformbaren Element (11) des Paars auf einer Rückseite (112) dieses ersten verformbaren Elements (11) eingerichtet ist und dass eine zweite elektroaktive Schicht (15), die sich von der ersten Schicht (14) unterscheidet, von den mindestens zwei elektroaktiven Schichten (14, 15) mit einem zweiten verformbaren Element (12) des Paars, das sich von dem ersten verformbaren Element (11) unterscheidet, auf einer Vorderseite (121) dieses zweiten verformbaren Elements (12) eingerichtet ist.

2. Mechanisches Mikrosystem (1) nach dem vorhergehenden Anspruch, weiterhin umfassend einen starren Rahmen (16), mit dem die verformbaren Elemente (11, 12) durch proximale Enden (113, 123) fest verbunden sind, wobei das mechanische Gelenk (13) die verformbaren Elemente (11, 12) des Paars durch ihre distalen Enden (114, 124) miteinander verbindet und wobei das mechanische Gelenk (13) flexibel ist, so dass eine Bewegung der verformbaren Elemente (11, 12) des Paars aus der Ruheebene heraus ermöglicht wird.

3. Mechanisches Mikrosystem (1) nach einem der vorhergehenden Ansprüche, wobei mindestens eine elektroaktive Schicht (14, 15), vorzugsweise jede elektroaktive Schicht (14, 15) auf einem elektroaktiven Material basiert, das ausgewählt ist aus: einem piezoelektrischen Material, einem ferromagnetischen Material und einem elektroaktiven Material auf PTZ-Basis.

4. Mechanisches Mikrosystem (1) nach einem der vorhergehenden Ansprüche, wobei die verformbaren Elemente (11, 12) und das mechanische Gelenk (13) auf der Basis desselben Materials sind, beispielsweise auf Siliciumbasis.

5. Mechanisches Mikrosystem (1) nach einem der vorhergehenden Ansprüche, weiterhin umfassend mindestens eine Zwischenschicht (17), die sich zwischen der ersten elektroaktiven Schicht (14) und dem ersten verformbaren Element (11) und/oder auf einer Seite und/oder der anderen Seite der ersten elektroaktiven Schicht (14) und des ersten verformbaren Elements (11) befindet und/oder sich zwischen der zweiten elektroaktiven Schicht (15) und dem zweiten verformbaren Element (12) und/oder auf einer Seite und/oder der anderen Seite der zweiten elektroaktiven Schicht (15) und des zweiten verformbaren Elements (12) befindet.

6. Mechanisches Mikrosystem (1) nach dem vorhergehenden Anspruch, wobei die mindestens eine Zwischenschicht (17) dazu konfiguriert ist, eine Wiederherstellung eines elektrischen Kontakts umzusetzen, insbesondere einen elektrischen Stromfluss in mindestens einer von der ersten und der zweiten elektroaktiven Schicht (14, 15), mit der die mindestens eine Zwischenschicht (17) zusammen eingerichtet ist, anzuwenden und/oder zu messen.

7. Mechanisches Mikrosystem (1) nach einem der vorhergehenden Ansprüche, wobei die mindestens eine Zwischenschicht (17) eingerichtet ist, so dass eine neutrale Faser (2) des mechanischen Mikrosystems (1) sich zwischen jeder elektroaktiven Schicht (14, 15) und dem verformbaren Element (11, 12), das mit dieser elektroaktiven Schicht (14, 15) eingerichtet ist, befindet.

8. Mechanisches Mikrosystem (1) nach einem der vorhergehenden Ansprüche, weiterhin umfassend mindestens ein zweites Paar von elastisch verformbaren Elementen, wobei die verformbaren Elemente des mindestens einen zweiten Paars durch das mechanische Gelenk, das zwischen den verformbaren (11, 12) des ersten Paars verbunden ist, oder durch ein mechanisches Gelenk, das sich von dem mechanischen Gelenk unterscheidet, das die verformbaren Elemente (11, 12) des ersten Paars miteinander verbindet, miteinander verbunden sind.

9. Verfahren zur Herstellung eines mechanischen Mikrosystems (1), umfassend:
a. Bereitstellen eines Substrats (101) auf der Basis eines ersten Materials auf einer Vorderseite (1011), auf der mindestens eine erste elektroaktive Schicht (14) und eine zweite elektroaktive Schicht (15) voneinander beabstandet gebildet sind, wobei das Substrat (101) weiterhin eine überdeckte Ätzstoppschicht (102) umfasst, die eine Öffnung (3) im Lot mit mindestens einem Teil der ersten elektroaktiven Schicht (14) aufweist,
b. Abscheiden einer so genannten passiven Schicht (103) auf der Basis eines zweiten Materials, die zumindest im Lot mit mindestens einem Teil der ersten elektroaktiven Schicht (14) ist, indem mindestens ein Teil der nicht abgedeckten zweiten elektroaktiven Schicht (15) der passiven Schicht (103) belassen wird,
c. Ätzen von mindestens einem zentralen Teil (1013) des Substrats (101) durch seine Rückseite (1012), bis der mindestens eine zentrale Teil (1013) des Substrats (101) auf seiner gesamten Dicke, der sich im Lot mit der Ätzstoppschicht (102) befindet, abgehoben ist und bis der mindestens eine zentrale Teil (1013) des Substrats (101) auf seiner gesamten Dicke direkt unter der Öffnung (3), die die Ätzstoppschicht (102) aufweist, abgehoben ist,
so dass die passive Schicht (103) ein erstes elastisch verformbares Element (11) bildet, das zusammen mit der ersten elektroaktiven Schicht (14) eingerichtet ist,
so dass das geätzte Substrat (101) ein zweites elastisch verformbares Element (12) bildet, das zusammen mit der zweiten elektroaktiven Schicht (15) eingerichtet ist, und so dass mindestens eines bzw. eine von dem geätzten Substrat (101) und der passiven Schicht (103) ein mechanisches Gelenk (13) bildet, das das erste und das zweiten verformbare Element (11, 12) miteinander verbindet.

10. Herstellungsverfahren nach dem vorhergehenden Anspruch, wobei die Bildung der ersten und der zweiten elektroaktiven Schicht (14, 15) die folgenden Schritte umfasst:
a. ein einziges Abscheiden eines Films aus einem elektroaktiven Material auf der Vorderseite (1011) des Substrats (101), dann
b. ein Ätzen des abgeschiedenen Films, wobei dieses Ätzen gegebenenfalls eine Ätzmaske einsetzt, um die erste und die zweite elektroaktive Schicht (14, 15) zu gestalten und voneinander zu trennen.

11. Herstellungsverfahren nach einem der zwei vorhergehenden Ansprüche, wobei nur der zentrale Teil (1013) des Substrats (101) geätzt wird, so dass der restliche Umfang des Substrats einen starren Rahmen (16) bildet, mit dem die verformbaren Elemente (11, 12) durch ihre proximalen Enden (113, 123) fest verbunden sind, wobei das mechanische Gelenk (13) die verformbaren Elemente (11, 12) durch ihre distalen Enden (114, 124) miteinander verbindet und wobei das mechanische Gelenk (13) flexibel ist, so dass eine Bewegung jedes verformbaren Elements (11, 12) aus der Ruheebene heraus ermöglicht wird.

12. Herstellungsverfahren nach dem vorhergehenden Anspruch, weiterhin umfassend einen Schritt eines Strukturierens des mechanischen Gelenks (13), insbesondere durch mindestens eine Materialabhebung (131), der Zone des Substrats (101) und/oder der passiven Schicht (103), die sich zwischen den verformbaren Elementen (11, 12) befindet.

13. Herstellungsverfahren nach einem der vier vorhergehenden Ansprüche, weiterhin umfassend das Abscheiden von mindestens einer Zwischenschicht (17), die sich zwischen der ersten elektroaktiven Schicht (14) und dem ersten verformbaren Element (11) und/oder auf einer Seite und/oder der anderen Seite der ersten elektroaktiven Schicht (14) und des ersten verformbaren Elements (11) befindet und/oder sich zwischen der zweiten elektroaktiven Schicht (15) und dem zweiten verformbaren Element (12) und/oder auf einer Seite und/oder der anderen Seite der zweiten elektroaktiven Schicht (15) und des zweiten verformbaren Elements (12) befindet.

14. Verfahren nach dem vorhergehenden Anspruch, wobei das Abscheiden der mindestens einen Zwischenschicht (17) parametrisiert ist, um eine Wiederherstellung eines elektrischen Kontakts umzusetzen, insbesondere einen elektrischen Stromfluss in der elektroaktiven Schicht (14, 15), mit der die mindestens eine Zwischenschicht (17) zusammen eingerichtet ist, anzuwenden und/oder zu messen.

15. Verfahren nach einem der fünf vorhergehenden Ansprüche, wobei das Abscheiden der passiven Schicht (103) parametrisiert ist, so dass die passive Schicht (103) eine Dicke aufweist, die im Wesentlichen gleich der Tiefe ist, in der die Ätzstoppschicht (102) in dem Substrat (101) von seiner Vorderseite (1011) überdeckt ist.

## Claims

1. Mechanical microsystem (1) comprising:
a. a pair of elastically deformable elements (11, 12),
b. a mechanical hinge (13) joining the deformable elements (11, 12) together, and
c. at least two electroactive layers (14, 15),
the mechanical microsystem (1) being configured such that, from a rest position wherein the deformable elements (11, 12) lie substantially in one and the same so-called rest plane, a deformation of at least one of the deformable elements (11, 12) displacing it at least partially out of the rest plane induces a flow of electric current in at least one of the at least two electroactive layers (14, 15), and/or vice versa,
each deformable element (11, 12) having a front face (111, 121) and a rear face (112, 122) opposite one another and substantially parallel to the rest plane,
the mechanical microsystem (1) being **characterised in that** a first (14) of the at least two electroactive layers (14, 15) is arranged together with a first deformable element (11) of the pair on a rear face (112) of this first deformable element (11), and **in that** a second electroactive layer (15) that is different from the first layer (14), of the at least two electroactive layers (14, 15) is arranged with a second deformable element (12) of the pair, that is different from the first element (11), on a front face (121) of this second deformable element (12).

2. Mechanical microsystem (1) according to the preceding claim, further comprising a rigid frame (16) to which the deformable elements (11, 12) are rigidly joined by proximal ends (113, 123), the mechanical hinge (13) joining the deformable elements (11, 12) of the pair to one another by the distal ends (114, 124) thereof, and wherein the mechanical hinge (13) is flexible so as to allow a movement of the deformable elements (11, 12) of the pair out of the rest plane.

3. Mechanical microsystem (1) according to any one of the preceding claims, wherein at least one electroactive layer (14, 15), preferably each electroactive layer (14, 15), has, as a main component, an electroactive material selected from: a piezoelectric material, a ferromagnetic material and a PTZ-based electroactive material.

4. Mechanical microsystem (1) according to any one of the preceding claims, wherein the deformable elements (11, 12) and the mechanical hinge (13) have, as a main component, one and the same material, for example silicon.

5. Mechanical microsystem (1) according to any one of the preceding claims, further comprising at least one intermediate layer (17) located between the first electroactive layer (14) and the first deformable element (11) and/or on either side of said first electroactive layer (14) and of the first deformable element (11), and/or located between the second electroactive layer (15) and the second deformable element (12) and/or on either side of said second electroactive layer (15) and of the second deformable element (12).

6. Mechanical microsystem (1) according to the preceding claim, wherein said at least one intermediate layer (17) is configured to make an electric contact point, in particular so as to apply and/or measure a flow of electric current in at least one of the first and second electroactive layers (14, 15) with which said at least one intermediate layer (17) is jointly arranged.

7. Mechanical microsystem (1) according to any one of the preceding two claims, wherein said at least one intermediate layer (17) is arranged such that a neutral fibre (2) of the mechanical microsystem (1) is located between each electroactive layer (14, 15) and the deformable element (11, 12) arranged with this electroactive layer (14, 15).

8. Mechanical microsystem (1) according to any one of the preceding claims, further comprising at least one second pair of elastically deformable elements, the deformable elements of said at least one second pair being joined together by the mechanical hinge joining together the deformable elements (11, 12) of the first pair or by a mechanical hinge that is different from the mechanical hinge joining together the deformable elements (11, 12) of the first pair.

9. Process for producing a mechanical microsystem (1), comprising:
a. Providing a substrate (101) having a first material as a main component, on a front face (1011) whereof at least a first electroactive layer (14) and a second electroactive layer (15) are formed in a spaced apart manner, the substrate (101) further comprising a buried etch stop layer (102) having an opening (3) vertically in line with at least a part of the first electroactive layer (14),
b. Depositing a so-called passive layer (103) having a second material as a main component, at least vertically in line with at least a part of the first electroactive layer (14), while leaving at least a part of the second electroactive layer (15) not covered by said passive layer (103),
c. Etching at least one central part (1013) of the substrate (101) through the rear face (1012) thereof, until said at least one central part (1013) of the substrate (101) is removed over the entirety of the thickness thereof located vertically to the etch stop layer (102) and until said at least one central part (1013) of the substrate (101) is removed over the entirety of the thickness thereof located opposite the opening (3) in the etch stop layer (102),
such that the passive layer (103) forms a first elastically deformable element (11) arranged together with the first electroactive layer (14),
such that the etched substrate (101) forms a second elastically deformable element (12) arranged together with the second electroactive layer (15), and
such that at least one of the etched substrate (101) and the passive layer (103) forms a mechanical hinge (13) joining together the first and second deformable elements (11, 12).

10. Production process according to the preceding claim, wherein the formation of the first and second electroactive layers (14, 15) comprises the following steps of:
a. depositing, one single time, a film made of an electroactive material on the front face (1011) of the substrate (101), then
b. etching the deposited film, this etching optionally implementing an etching mask, so as to pattern and separate the first and second electroactive layers (14, 15) from one another.

11. Production process according to any one of the preceding two claims, wherein only the central part (1013) of the substrate (101) is etched such that the remaining periphery of the substrate forms a rigid frame (16) to which the deformable elements (11, 12) are rigidly joined by the proximal ends (113, 123) thereof, the mechanical hinge (13) joining the deformable elements (11, 12) to one another by the distal ends (114, 124) thereof, and wherein the mechanical hinge (13) is flexible so as to allow a movement of each deformable element (11, 12) out of the rest plane.

12. Production process according to the preceding claim, further comprising a step of patterning the mechanical hinge (13), in particular by at least one removal of material (131), from the area of the substrate (101) and/or the passive layer (103) located between the deformable elements (11, 12).

13. Production process according to one of the preceding four claims, further comprising depositing at least one intermediate layer (17) located between the first electroactive layer (14) and the first deformable element (11) and/or on either side of said first electroactive layer (14) and of the first deformable element (11), and/or located between the second electroactive layer (15) and the second deformable element (12) and/or on either side of said second electroactive layer (15) and of the second deformable element (12).

14. Process according to the preceding claim, wherein the deposition of said at least one intermediate layer (17) is configured to make an electric contact point, in particular so as to apply and/or measure a flow of electric current in the electroactive layer (14, 15) with which said at least one intermediate layer (17) is jointly arranged.

15. Process according to any one of the preceding five claims, wherein the deposition of the passive layer (103) is configured such that the passive layer (103) has a thickness substantially equal to the depth to which the etch stop layer (102) is buried in the substrate (101) from the front face (1011) thereof.
